# EUROPÄISCHE PATENTSCHRIFT

(11) **EP 3 304 102 B1**
(45) Veröffentlichungstag und Bekanntmachung des Hinweises auf die Patenterteilung: **24.07.2019**
(21) Anmeldenummer: 16723065.5
(22) Anmeldetag: 10.05.2016
(51) Int. Cl.: G01R 23/06, G01R 23/12, G01S 13/40

(54) **VERFAHREN ZUR DETEKTION VON HOCHFREQUENZSIGNALEN**
METHOD FOR DETECTING HIGH-FREQUENCY SIGNALS
PROCÉDÉ DE DÉTECTION DE SIGNAUX HAUTE FRÉQUENCE

(30) Priorität: 03.06.2015 DE 102015108852
(43) Veröffentlichungstag der Anmeldung: 11.04.2018
(73) Patentinhaber: Endress+Hauser SE+Co. KG, 79689 Maulburg (DE)
(72) Erfinder: BLÖDT, Thomas, 79585 Steinen (CH); SCHWALL, Timo, 78467 Konstanz (DE)
(74) Vertreter: Andres, Angelika Maria
(86) Internationale Anmeldenummer: PCT/EP2016/060395
(87) Internationale Veröffentlichungsnummer: WO 2016/192932

(56) Entgegenhaltungen:
- JP-A- S59 195 166
- US-A1- 2014 239 938

## Beschreibung

Die Erfindung bezieht sich auf ein Verfahren zur Detektion von Hochfrequenzsignalen im Bereich von 2.4 GHz. Bei solchen Hochfrequenzsignalen soll die exakte Frequenz gemessen werden und diese in einen digitalen Wert umgewandelt werden. Die Ausgangsleistung des Hochfrequenzsignals beträgt max. ca. 1 mW. Die Frequenzbandbreite des Hochfrequenzsignals beträgt üblicherweise ca. 35 MHz.

In der Automatisierungstechnik, insbesondere in der Prozessautomatisierung aber auch in der Fabrikautomatisierung, werden Feldgeräte eingesetzt, die zur Bestimmung und Überwachung von Prozessvariablen dienen. Unter dem Begriff 'Feldgeräte' werden in Zusammenhang mit der Erfindung sowohl Aktoren als auch Sensoren verstanden. Sensoren erfassen beispielsweise die verschiedenen Prozessvariablen, wie Füllstand, Durchfluss, pH-Wert, Trübung, Stoffkonzentration, Druck, Temperatur, Feuchte, Leitfähigkeit, Dichte und Viskosität. Eine Vielzahl solcher Feldgeräte wird von der Firmengruppe Endress + Hauser angeboten und vertrieben. Solche Feldgeräte erzeugen Signale im Hochfrequenzbereich, die zunächst einmal ausgewertet werden müssen, damit aus der Auswertung des Hochfrequenzsignals die Prozessvariable bestimmt werden kann.

Nach dem Stand der Technik wird die Frequenz eines Hochfrequenzsignals durch schnelle Zähler bestimmt. Hierzu wird die Frequenz mehrmals heruntergeteilt damit die Frequenz für digitale ICs weiterverwertbar wird. Alternativ oder zusätzlich kann auch ein Mischer verwendet werden um den Frequenzoffset (im vorliegenden Fall die 2.4 GHz) zu beseitigen. Allerdings stoßen diese Konzepte bei hohen Frequenzen an gewisse Grenzen. Das generelle Problem bei Frequenzteilern ist, dass die eigentliche Nutzfrequenz ebenfalls durch denselben Faktor geteilt wird, was bedeutet dass man genauer messen muss. Auch reichen "normale" Digitalschaltungen meist nur in Frequenzbereichen von einigen 100 MHz. Bausteine für höhere Frequenzen sind meist teuer und/oder besitzen eine erhöhte Stromaufnahme. Mischer sind ebenfalls teuer und haben meist eine hohe Stromaufnahme bzw. einen hohen Konversionsverlust. Weiterhin muss einem Mischer wiederum ein hochfrequentes Referenz-Signal mit einer sehr genau eingehaltenen Frequenz zugeführt werden.

In der japanischen Patentschrift JP S59 195 166 wird eine Vorrichtung zur Bestimmung der Frequenz von Wechselspannungs-Signalen gezeigt. Dabei wird das Wechselspannungssignal in ein Referenzsignal und ein zweites Signal gefiltert. Das Referenzsignal wird dabei direkt gleichgerichtet, während das zweite Signal frequenzabhängig gefiltert wird, bevor es gleichgerichtet wird. Durch Vergleich der Amplituden der zwei gleichgerichteten Signale wird die Frequenz ermittelt.

Auch die US-Veröffentlichungsschrift 2014/239938 A1 zeigt eine Vorrichtung zur Bestimmung der Frequenz von Wechselspannungs-Signalen. Dort wird das Wechselspannungssignal in zwei Signalpfade aufgeteilt, wo sie unterschiedlich gefiltert und gleichgerichtet werden. Durch Vergleich der Amplituden der zwei unterschiedlich gefilterten Signale wird wiederum die Frequenz ermittelt.

Der Erfindung liegt die Aufgabe zugrunde, ein Verfahren und eine Vorrichtung bereitzustellen, welche die Frequenz von Hochfrequenzsignalen mit einfachen Mitteln präzise bestimmen.

Die Aufgabe wird durch den Gegenstand der Erfindung gelöst. Gegenstand der Erfindung ist ein Verfahren zur Detektion von Hochfrequenzsignalen, umfassend die Verfahrensschritte: Aufteilen eines Hochfrequenzsignals in ein Rohsignal und ein Referenzsignal, Dämpfen des Rohsignals zu einem Dämpfungssignal, wobei das Dämpfen in Abhängigkeit der Frequenz des Rohsignals entsprechend einer Dämpfungskennlinie geschieht, Gleichrichten des Dämpfungssignals, so dass eine erste Gleichspannung generiert wird, Gleichrichten des Referenzsignals, so dass eine zweite Gleichspannung generiert wird, Ermitteln einer Dämpfung aus dem Verhältnis zwischen der ersten und zweiten Gleichspannung, wobei das Verhältnis einem Dämpfungsfaktor der Dämpfung des Rohsignals entspricht,
Bestimmen der Frequenz des Hochfrequenzsignals aus dem Dämpfungsfaktor und einer Dämpfungskennlinie.

Ein großer Vorteil dieses Verfahrens ist die niedrige Anzahl an benötigten Bauteilen. Da die meisten HF-Komponenten mit Leitungselementen realisiert sind, fallen Toleranzen und Temperaturabhängigkeiten wesentlich weniger ins Gewicht als beim Aufbau mit passiven oder gar aktiven Bauelementen. Des Weiteren ist das Verfahren sehr günstig, da wenige und vor allem wenige aktive Bauteile verwendet werden. Ein weiterer Vorteil ist die geringe Energieaufnahme. Bis auf Verstärker zur Pegelanpassung und einen A/D-Wandler wird keine externe Energieversorgung benötigt. Die Zeit, die der A/D-Wandler braucht, um einen anliegenden Wert zu wandeln und damit die Zeit die eine externe Energieversorgung gebraucht wird ist relativ kurz und liegt typischerweise in der Größenordnung von 20-30 Taktzyklen. Auch spielt der absolute Pegel der Schaltung am Eingang keine Rolle mehr, da diese als Referenz für den A/D- Wandler verwendet wird.

Gemäß der Erfindung geschieht das Dämpfen des Rohsignals zu einem Dämpfungssignal durch Verteilen des Rohsignals auf mindestens einer ersten und zweiten Leitung eines Dämpfungsglieds, wobei die erste und zweite Leitung unterschiedliche Längen aufweisen, wodurch ein frequenzabhängiger Phasenunterschied zwischen einem ersten Signal der ersten Leitung und einem zweiten Signal der zweiten Leitung entsteht, wobei das erste und zweite Signal an einem Ausgang des Dämpfungsglieds zu dem Dämpfungssignal überlagert werden.

Gemäß einer günstigen Variante werden die erste und zweite Gleichspannung digitalisiert, bevor die Dämpfung ermittelt wird.

Die Aufgabe der Erfindung wird ebenfalls durch ein Verfahren zur Bestimmung einer physikalischen oder chemischen Prozessgröße, umfassend mindestens einen Sensor, der Hochfrequenzsignale erzeugt, deren Frequenz mit der mindestens einen Prozessgröße variiert, umfassend die Schritte,
Detektieren der Hochfrequenzsignale mittels eines erfindungsgemäßen Verfahrens, gelöst.

Die Aufgabe der Erfindung wird weiterhin durch eine Vorrichtung gelöst. Die Vorrichtung zur Detektion von Hochfrequenzsignalen, umfasst ein Signalteiler zum Aufteilen eines Hochfrequenzsignals auf ein Rohsignal und ein Referenzsignal, ein Dämpfungsglied zum Dämpfen des Rohsignals, wobei das Dämpfungsglied eine definierte Dämpfungskennlinie aufweist, ein erster Gleichrichter zum Gleichrichten des Dämpfungssignals zu einer ersten Gleichspannung, ein zweiter Gleichrichter zum Gleichrichten des Referenzsignals zu einer zweiten Gleichspannung, ein Komparator zum Bilden des Verhältnisses zwischen der ersten und zweiten Gleichspannung, ein Prozessor zum Ermitteln der Frequenz des Hochfrequenzsignals aus der Dämpfung des Rohsignals und der Dämpfungskennlinie des Dämpfungsglieds.

Gemäß der Erfindung umfasst das Dämpfungsglied mindestens eine erste und eine zweiten Leitung zum Verteilen des Rohsignals, wobei die mindestens erste und zweite Leitung unterschiedliche Längen aufweisen, so dass ein frequenzabhängiger Phasenunterschied zwischen einem ersten Signal der ersten Leitung und einem zweiten Signal der zweiten Leitung entsteht, wobei das Dämpfungsglied eine Zusammenführung an einem Ausgang zum Überlagern des ersten und zweiten Signals aufweist, so dass das erste und zweite Signal an dem Ausgang zu einem Dämpfungssignal überlagert werden. Gemäß einer günstigen Weiterbildung umfasst die Vorrichtung weiterhin ein A/D-Wandler zum Digitalisieren der ersten und zweiten Gleichspannung.

Die Aufgabe der Erfindung wird ebenfalls durch ein Feldgerät zur Messung einer physikalischen oder chemischen Prozessgröße, umfassend mindestens einen Sensor, der Hochfrequenzsignale erzeugt, deren Frequenz mit der mindestens einen Prozessgröße variiert, und eine erfindungsgemäße Vorrichtung zur Auswertung der Hochfrequenzsignale, gelöst.

Die Erfindung wird anhand der nachfolgenden Zeichnungen näher erläutert. Es zeigt:
Fig. 1: eine skizzierte Ansicht einer Vorrichtung zur Detektion von Hochfrequenzsignalen,
Fig. 2: eine Skizze einer Schaltung zur Realisierung einer Vorrichtung entsprechend Fig. 1,
Fig. 3: eine Skizze einer Schaltung entsprechend Fig. 2, mit einem T-Glied zur Leistungsanpassung,
Fig. 4: eine Grafik einer typischen Dämpfungskennlinie eines Dämpfungsglieds entsprechend Fig. 2 bzw. Fig. 3.
Fig. 5: eine Skizze eines Wilkinsonteilers, bei dem das Dämpfungsglied in den Wilkinsonteiler integriert ist,
Fig. 6: eine Skizze eines Signalteilers, welcher das Hochfrequenzsignal in drei Signalteile aufteilt, und
Fig. 7: eine Skizze eines Dämpfungsglieds mit zwei Leitungen mit unterschiedlichen DK-Werten.

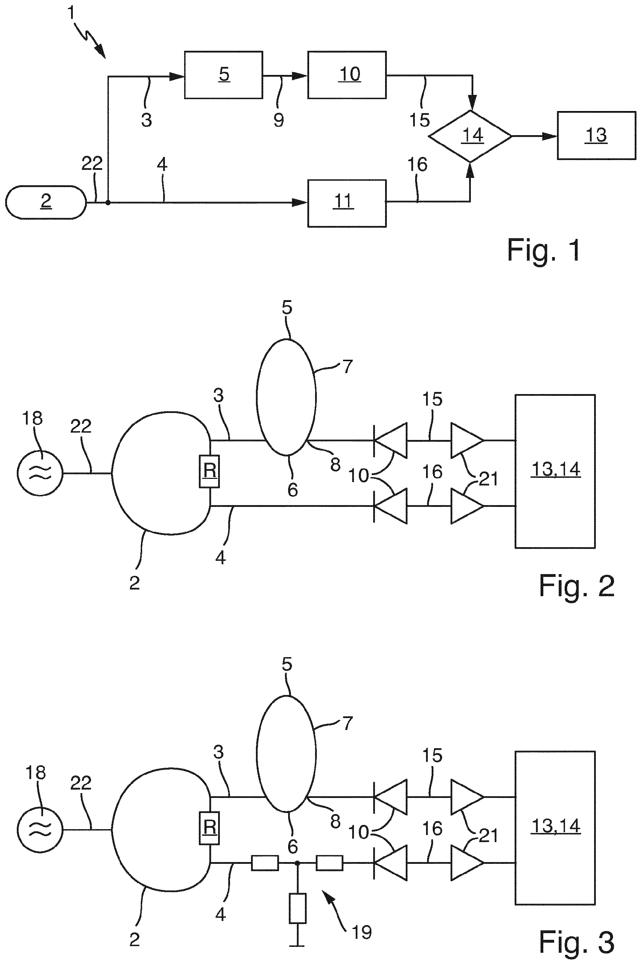

Fig. 1 zeigt eine skizzierte Ansicht einer Vorrichtung 1 zur Detektion von Hochfrequenzsignalen 22. Die Vorrichtung 1 umfasst einen Signalteiler 2, welcher in der Lage ist ein Hochfrequenzsignal 22 auf ein Rohsignal 3 und ein Referenzsignal 4 aufzuteilen. Das Rohsignal 3 wird einem Dämpfungsglied 5 zugeführt. Das Dämpfungsglied 5 dämpft das Rohsignal 3 zu einem Dämpfungssignal 9.

Das Dämpfungssignal 9 wird einem ersten Gleichrichter 10 zugeführt, wodurch das Dämpfungssignal 9 zu einer ersten Gleichspannung 15 gleichgerichtet wird. Gleichzeitig wird das Rohsignal 3 einem zweiten Gleichrichter 11 zugeführt, wodurch das Referenzsignals 4 zu einer zweiten Gleichspannung 16 gleichgerichtet wird.

Die erste und zweite Gleichspannung 15, 16 werden in einem A/D-Wandler 14 verglichen. Das Verhältnis zwischen der ersten und zweiten Gleichspannung 15, 16 entspricht einer Dämpfung des Rohsignals 3 in dem Dämpfungsglied 5.

Ein Prozessor 13 ermittelt die Frequenz des Hochfrequenzsignals 22 aus der Dämpfung des Rohsignals 3 und eine Dämpfungskennlinie des Dämpfungsglieds 5.

Fig. 2 zeigt eine Skizze einer Schaltung zur Realisierung einer Vorrichtung entsprechend Fig. 1. Eine Signalquelle 18 erzeugt ein Hochfrequenzsignal 22, welches im ersten Schritt einen Signalteiler 2 durchläuft, wobei der Signalteiler 2 als ein Wilkinsonteiler ausgestaltet ist. Der Signalteiler 2 verteilt das Hochfrequenzsignal 22 gleichmäßig auf ein Rohsignal 3 und einen Referenzsignal 4. Ein Widerstand R verbindet das Rohsignal 3 und das Referenzsignal 4, wobei der Widerstand R 100 Ohm beträgt.

Das Rohsignal 3 durchläuft ein Dämpfungsglied 5. Das Dämpfungsglied 5 besteht aus einer ersten und zweiten Leitung 6, 7, wobei die erste und zweite Leitung 6, 7 unterschiedliche Längen aufweisen. Auf diese Weise wird das Rohsignal 3 in einen ersten und einen zweiten Teil aufgeteilt und an einem Ausgang 8 des Dämpfungsglieds 5 wieder zusammengefügt.

Durch das Aufteilen des Rohsignals 3 auf zwei Leitungen 6, 7 mit unterschiedlichen Längen werden die Phasen des ersten und zweiten Teils des Rohsignals frequenzabhängig unterschiedlich gedreht. Durch das Zusammenfügen an dem Ausgang 8 entsteht eine Interferenz. Die Amplitude ist nun abhängig von der Phasenlage des ersten und zweiten Teils des Rohsignals 3 zueinander.

Der Vorteil dieses Dämpfungsglieds 5 ist im Vergleich zu einem Dämpfungsglied mit passiven Bauteilen die geringere Temperaturabhängigkeit und niedrigeren Toleranzen. Die Ätztoleranzen bei modernen Verfahren liegen bei weniger als 75 Mikrometer, was im angegebenen Frequenzbereich viel kleiner ist als die Wellenlänge und somit nicht ins Gewicht fällt. Die Temperaturabhängigkeit bei diesem Dämpfungsglied 5 wird durch zwei Aspekte beeinflusst. Zum einen die DK-Änderung über den Temperaturbereich, welche bei den hier vorliegenden Frequenzen vernachlässigt werden kann. Zum anderen ist es die temperaturbedingte Ausdehnung des Kupfers, welche ebenfalls relativ klein ist. Über einen Temperaturbereich von 160K beträgt die maximale Längenänderung des Kupfers im Verhältnis zur Wellenlänge ca. 1 zu 350. Somit ist der Einfluss der Wärmeausdehnung des Kupfers auf Leitungsgrößen wie zum Beispiel Länge, Laufzeit, Phasengang, Breite und Impedanz, vernachlässigbar gering.

Nach dem Dämpfen des Rohsignals 3 im Dämpfungsglied 5 wird das Dämpfungssignal 9 mittels der ersten Gleichrichterschaltung 10, die als eine Gleichrichterdiode ausgestaltet ist, zu einer ersten Gleichspannung 15 gleichgerichtet. Gleichzeitig wird das Referenzsignal 4 mittels der zweiten Gleichrichterschaltung 11, die ebenfalls als eine Gleichrichterdiode ausgestaltet ist, zu einer zweiten Gleichspannung 16 gleichgerichtet.

Die erste und zweite Gleichspannung 15, 16 dienen zur eigentlichen Bestimmung der Amplitude des Rohsignals 3 bzw. des Referenzsignals 4. Die erste und zweite Gleichrichterschaltung 10, 11 können außer den Gleichrichterdioden mindestens einen Kondensator (nicht dargestellt) enthalten. Die Gleichrichterdioden schneiden eine der Halbwellen des Rohsignals 3 bzw. des Referenzsignals 4 ab. Mithilfe des mindestens einen Kondensators wird die übrige Halbwelle geglättet und es entsteht eine Gleichspannung.

Die erste und zweite Gleichspannung 15, 16 werden jeweils mittels eines Verstärkers 21 verstärkt. Anschließend werden die erste und zweite Gleichspannung 15, 16 einem A/D-Wandler 14 zugeführt. In dem A/D-Wandler 14 werden die erste und zweite Gleichspannung 15, 16 verglichen. Hierzu können das Rohsignal 3 und das Referenzsignal 4 digitalisiert werden. Je nach Beschaffenheit des A/D-Wandlers 14 muss unter Umständen ein Vorverstärker verwendet werden um den A/D-Wandler 14 den nötigen Pegel zu liefern.

Fig. 3 zeigt eine Skizze einer Schaltung entsprechend Fig. 2, mit einem T-Glied 19 zur Leistungsanpassung. Das T-Glied 19 ist vorgesehen, um das Referenzsignal 4 durch das T-Glied zu filtern. Die Filterung des Referenzsignals 4 durch das T-Glied 19 bewirkt, dass das Hochfrequenzsignal 22 zu gleichen Leistungsanteilen in ein Rohsignal 3 und einen Referenzsignal 4 aufgeteilt wird. Eine asymmetrische Leistungsaufteilung des Hochfrequenzsignals 22 ist ebenfalls möglich. Dies kann durch eine entsprechende Dimensionierung des T-Glieds 19 bewirkt werden.

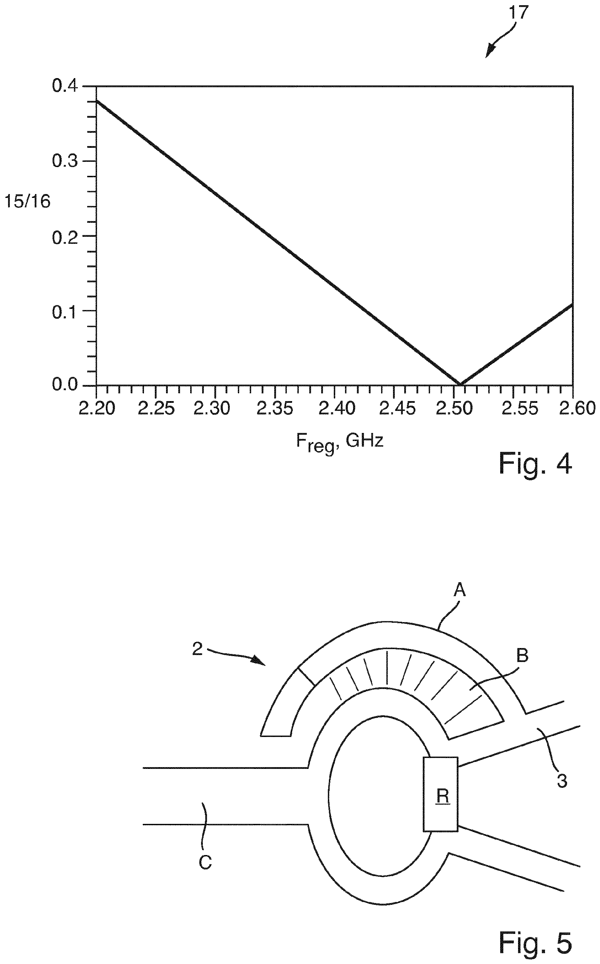

Fig. 4 zeigt eine Grafik einer typischen Dämpfungskennlinie 17 eines Dämpfungsglieds entsprechend Fig. 2 bzw. Fig. 3. Die Dämpfungskennlinie 17 muss vor Inbetriebnahme der Schaltung bekannt sein. Die Abszisse beschreibt die Frequenz und die Ordinate beschreibt das Verhältnis der Amplituden der ersten und zweiten Gleichspannung 15, 16. Wird aus der Schaltung entsprechend Fig. 2 bzw. Fig. 3 ein Verhältnis der Gleichspannungen ermittelt, kann eine zu diesem Verhältnis gehörende Frequenz aus der Dämpfungskennlinie 17 abgelesen werden. Diese Frequenz kann dem Hochfrequenzsignal 22 zugeordnet werden, dessen Frequenz zu bestimmen ist.

Fig. 5 zeigt eine Skizze eines Signalteilers 2, der als ein Wilkinsonteiler ausgestaltet ist, bei dem das Dämpfungsglied in den Wilkinsonteiler integriert ist. An einer das Rohsignal 3 führenden Leitung ist eine Abzweigung A angeordnet, die an der das Rohsignal 3 führenden Leitung anliegt. Die Abzweigung A ist länger als die das Rohsignal 3 führende Leitung, somit ergibt sich eine längere Laufzeit des Rohsignals 3 in der Abzweigung A. Das Rohsignal 3 läuft über die Abzweigung A zurück und wird am Ende Abzweigung A reflektiert. Die Abzweigung A und deren Abstand sind so gewählt, dass das Rohsignal 3 zu einem Großteil überkoppelt, wenn es wieder den Anfang von Leitung A erreicht. Hierdurch entsteht eine Interferenz beim Rohsignal 3, wodurch das Dämpfungsglied realisiert ist. C ist hier die Zuleitung und R ein optionaler Widerstand. Durch die unterschiedlichen Längen der Abzweigung A und der Rest der Leitung, tritt der gewünschte Interferenzeffekt auf, der in Fig. 4 erläutert wurde.

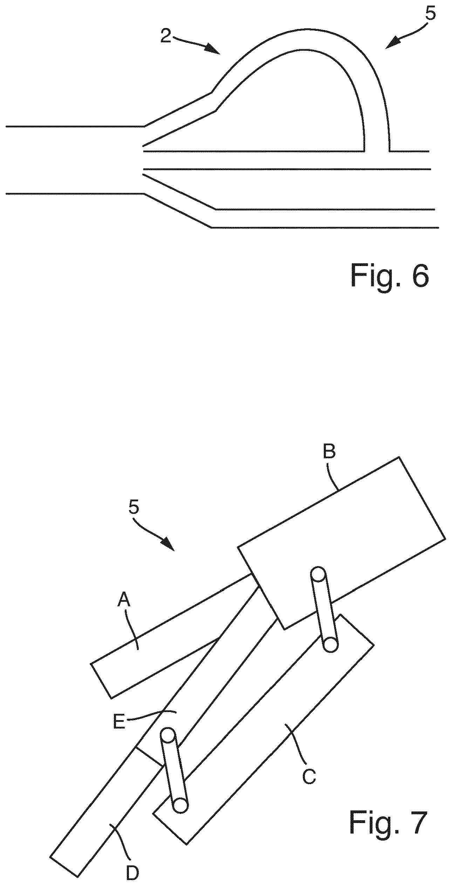

Fig. 6 zeigt eine Skizze eines Signalteilers 2, welcher das Hochfrequenzsignal 22 in drei Signalteile aufteilt. Das Dämpfungsglied 5 ist ebenfalls bereits im Signalteiler 2 realisiert. Auf diese Weise ist es möglich Baugruppen zu sparen.

Fig. 7 zeigt eine Skizze eines Dämpfungsglieds 5 mit zwei Leitungen mit unterschiedlichen DK-Werten, anstelle von zwei Leitungen mit unterschiedlichen Längen. Dies hat den Vorteil, dass so Platz auf der Leiterkarte gespart werden kann. Die Leiterkarte muss allerdings aus mindestens zwei Lagen bestehen.

### Bezugszeichenliste

- 1: Vorrichtung
- 2: Signalteiler
- 3: Rohsignal
- 4: Referenzsignal
- 5: Dämpfungsglied
- 6: Erste Leitung
- 7: Zweite Leitung
- 8: Ausgang des Dämpfungsglieds
- 9: Dämpfungssignal
- 10: Erster Gleichrichter
- 11: Zweiter Gleichrichter
- 13: Prozessor
- 14: A/D-Wandler
- 15: Erste Gleichspannung
- 16: Zweite Gleichspannung
- 17: Dämpfungskennlinie
- 18: Signalquelle
- 19: T-Glied
- 20: Gelichrichterdioden
- 21: Verstärker
- 22: Hochfrequenzsignal
- R: Widerstand

## Patentansprüche

1. Verfahren zur Detektion von Hochfrequenzsignalen (22), umfassend die Verfahrensschritte:
Aufteilen eines Hochfrequenzsignals (22) in ein Rohsignal (3) und ein Referenzsignal (4),
Dämpfen des Rohsignals (3) zu einem Dämpfungssignal (9), wobei das Dämpfen in Abhängigkeit der Frequenz des Rohsignals (3) entsprechend einer Dämpfungskennlinie geschieht, wobei das Dämpfen des Rohsignals (3) zu einem Dämpfungssignal (9) durch Verteilen des Rohsignals (3) auf mindestens einer ersten und zweiten Leitung (6, 7) eines Dämpfungsglieds (5) geschieht, wobei die erste und zweite Leitung (6, 7) unterschiedliche Längen aufweisen, wodurch ein frequenzabhängiger Phasenunterschied zwischen einem ersten Signal der ersten Leitung (6) und einem zweiten Signal der zweiten Leitung (7) entsteht, wobei das erste und zweite Signal an einem Ausgang (8) des Dämpfungsglieds (5) zu dem Dämpfungssignal (9) überlagert werden,
Gleichrichten des Dämpfungssignals (9), so dass eine erste Gleichspannung (15) generiert wird,
Gleichrichten des Referenzsignals (4), so dass eine zweite Gleichspannung (16) generiert wird,
Ermitteln einer Dämpfung aus dem Verhältnis zwischen der ersten und zweiten Gleichspannung (15, 16), wobei das Verhältnis einem Dämpfungsfaktor der Dämpfung des Rohsignals (3) entspricht,
Bestimmen der Frequenz des Hochfrequenzsignals (22) aus dem Dämpfungsfaktor und einer Dämpfungskennlinie (17).

2. Verfahren nach Anspruch 1, wobei die erste und zweite Gleichspannung (15, 16) digitalisiert werden, bevor die Dämpfung ermittelt wird.

3. Verfahren zur Bestimmung einer physikalischen oder chemischen Prozessgröße, umfassend mindestens einen Sensor, der Hochfrequenzsignale erzeugt, deren Frequenz mit der mindestens einen Prozessgröße variiert, umfassend die Schritte,
Detektieren der Hochfrequenzsignale mittels eines Verfahrens nach mindestens einem der Ansprüche 1 bis 2.

4. Vorrichtung zur Detektion von Hochfrequenzsignalen (22), umfassend,
ein Signalteiler (2) zum Aufteilen eines Hochfrequenzsignals (22) auf ein Rohsignal (3) und ein Referenzsignal (4),
ein Dämpfungsglied (5) zum frequenzabhängigen Dämpfen des Rohsignals (3), wobei das Dämpfungsglied (5) mindestens eine erste und eine zweiten Leitung (6, 7) zum Verteilen des Rohsignals (3) umfasst, wobei die mindestens erste und zweite Leitung (6, 7) unterschiedliche Längen aufweisen, so dass ein frequenzabhängiger Phasenunterschied zwischen einem ersten Signal der ersten Leitung (6) und einem zweiten Signal der zweiten Leitung (7) entsteht, wobei das Dämpfungsglied (5) eine Zusammenführung an einem Ausgang (8) zum Überlagern des ersten und zweiten Signals aufweist, so dass das erste und zweite Signal an dem Ausgang (8) zu einem Dämpfungssignal (9) überlagert werden,
wobei das Dämpfungsglied (5) eine definierte Dämpfungskennlinie (17) aufweist,
ein erster Gleichrichter (10) zum Gleichrichten des Dämpfungssignals (9) zu einer ersten Gleichspannung (15),
ein zweiter Gleichrichter (11) zum Gleichrichten des Referenzsignals (4) zu einer zweiten Gleichspannung (16),
ein Komparator zum Bilden des Verhältnisses zwischen der ersten und zweiten Gleichspannung (10, 11),
ein Prozessor (13) zum Ermitteln der Frequenz des Hochfrequenzsignals (22) aus der Dämpfung des Rohsignals (3) und der Dämpfungskennlinie (17) des Dämpfungsglieds (4).

5. Vorrichtung nach Anspruch 4, weiterhin umfassend einen A/D-Wandler (14) zum Digitalisieren der ersten und zweiten Gleichspannung (15, 16).

6. Vorrichtung nach mindestens einem der Ansprüche 4 oder 5, wobei der Signalteiler (2) als ein Wilkinson-Teiler ausgestaltet ist.

7. Feldgerät zur Messung einer physikalischen oder chemischen Prozessgröße, umfassend mindestens einen Sensor, der Hochfrequenzsignale erzeugt, deren Frequenz mit der mindestens einen Prozessgröße variiert, und
eine Vorrichtung nach mindestens einem der Ansprüche 4 bis 6, zur Auswertung der Hochfrequenzsignale.

## Claims

1. Procedure to detect high frequency signals (22), comprising the following steps:
Division of a high frequency signal (22) into a raw signal (3) and a reference signal (4),
Attenuation of the raw signal (3) to an attenuation signal (9), wherein the attenuation is performed as a function of the frequency of the raw signal (3) in accordance with an attenuation characteristic curve, wherein the attenuation of the raw signal (3) to an attenuation signal (9) is performed by dividing the raw signal (3) to at least a first and a second line (6, 7) of an attenuator, wherein the first and the second line (6, 7) have different lengths as a result of which a frequency-dependent phase difference occurs between a first signal of the first line (6) and a second signal of the second line (7), wherein the first and the second signal are superimposed at an output (8) of the attenuator (5) to form the attenuation signal (9),
Rectification of the attenuation signal (9) so that a first DC voltage (15) is generated,
Rectification of the reference signal (4) so that a second DC voltage (16) is generated,
Determination of an attenuation from the ratio between the first and the second DC voltage (15, 16), wherein the ratio corresponds to an attenuation factor of the attenuation of the raw signal (3),
Determination of the frequency of the high frequency signal (22) from the attenuation factor and an attenuation characteristic curve (17).

2. Procedure as claimed in Claim 1, wherein the first and the second DC voltage (15, 16) are digitized before the attenuation is determined.

3. Procedure to determine a physical or chemical process variable, comprising at least one sensor that generates high frequency signals whose frequency varies with the at least one process variable, comprising the steps for detecting the high frequency signals using a procedure as claimed in at least one of the Claims 1 to 2.

4. Apparatus for the detection of high frequency signals (22), comprising
a signal divider (2) designed to divide a high frequency signal (22) into a raw signal (3) and a reference signal (4),
an attenuator (5) designed for the frequency-dependent attenuation of the raw signal (3),
wherein the attenuator (5) comprises at least a first and a second line (6, 7) for the distribution of the raw signal (3), wherein the at least first and second line (6, 7) have different lengths such that a frequency-dependent phase difference occurs between a first signal of the first line (6) and a second signal of the second line (7), wherein the attenuator (5) has a junction at an output (8) for the superimposition of the first and second signal such that the first and the second signal are superimposed at the output (8) in an attenuation signal (9),
wherein the attenuator (5) has a defined attenuation characteristic curve (17),
a first rectifier (10) designed to rectify the attenuation signal (9) to a first DC voltage (15),
a second rectifier (11) designed to rectify the reference signal (4) to a second DC voltage (16),
a comparator to form the ratio between the first and the second DC voltage (10, 11),
a processor (13) designed to determine the frequency of the high frequency signal (22) from the attenuation of the raw signal (3) and the attenuation characteristic curve (17) of the attenuator (5).

5. Apparatus as claimed in Claim 4, further comprising an A/D converter (14) designed to digitize the first and the second DC voltage (15, 16).

6. Apparatus as claimed in at least one of the Claims 4 or 5, wherein the signal divider (2) is designed as a Wilkinson divider.

7. Field device for measuring a physical or chemical process variable, comprising at least one sensor that generates high frequency signals whose frequency varies with the at least one process variable, and
an apparatus as claimed in at least one of the Claims 4 to 6, designed to evaluate the high frequency signals.

## Revendications

1. Procédé destiné à la détection de signaux haute fréquence (22), comprenant les étapes de procédé suivantes :
Division d'un signal haute fréquence (22) en un signal brut (3) et un signal de référence (4),
Atténuation du signal brut (3) en un signal d'atténuation (9), l'atténuation s'effectuant en fonction de la fréquence du signal brut (3) conformément à une courbe caractéristique d'atténuation, l'atténuation du signal brut (3) en un signal d'atténuation (9) s'effectuant par la répartition du signal brut (3) sur au moins une première et une deuxième ligne (6, 7) d'un atténuateur, la première et la deuxième ligne (6, 7) présentant différentes longueurs, si bien qu'il en résulte une différence de phase fonction de la fréquence entre un premier signal de la première ligne (6) et un deuxième signal de la deuxième ligne (7), le premier et le deuxième signal étant superposés au niveau d'une sortie (8) de l'atténuateur (5) pour former le signal d'atténuation (9),
Redressement du signal d'atténuation (9), de telle sorte qu'une première tension continue (15) soit générée,
Redressement du signal de référence (4), de telle sorte qu'une deuxième tension continue (16) soit générée,
Détermination d'une atténuation à partir d'un rapport entre la première et la deuxième tension continue (15, 16), le rapport correspondant à un facteur de l'atténuation du signal brut (3),
Détermination de la fréquence du signal haute fréquence (22) à partir du facteur d'atténuation et d'une courbe caractéristique d'atténuation (17).

2. Procédé selon la revendication 1, pour lequel la première et la deuxième tension continue (15, 16) sont numérisées avant que l'atténuation ne soit déterminée.

3. Procédé destiné à la détermination d'une grandeur de process physique ou chimique, comprenant au moins un capteur, qui génère des signaux haute fréquence, dont la fréquence varie avec l'au moins une grandeur de process, lequel procédé comprend les étapes de détection des signaux haute fréquence au moyen d'un procédé selon au moins l'une des revendications 1 à 2.

4. Dispositif destiné à la détection de signaux haute fréquence (22), comprenant
un diviseur de signal (2) destiné à diviser un signal haute fréquence (22) en un signal brut (3) et un signal de référence (4),
un atténuateur (5) destiné à une atténuation fonction de la fréquence du signal brut (3),
l'atténuateur (5) comprenant au moins une première et une deuxième ligne (6, 7) destinée à répartir le signal brut (3), l'au moins première et deuxième ligne (6, 7) présentant des longueurs différentes, si bien qu'il en résulte une différence de phase fonction de la fréquence entre un premier signal de la première ligne (6) et un deuxième signal de la deuxième ligne (7), l'atténuateur (5) présentant une jonction au niveau d'une sortie (8) destinée à superposer le premier et le deuxième signal, si bien que le premier et le deuxième signal sont superposés au niveau de la sortie (8) en un signal d'atténuation (9),
l'atténuateur (5) présentant une courbe caractéristique d'atténuation (17) définie,
un premier redresseur (10) destiné au redressement du signal d'atténuation (9) en une première tension continue (15),
un deuxième redresseur (11) destiné au redressement du signal de référence (4) en une deuxième tension continue (16),
un comparateur destiné à former le rapport entre la première et la deuxième tension continue (10, 11),
un processeur (13) destiné à la détermination de la fréquence du signal haute fréquence (22) à partir de l'atténuation du signal brut (3) et de la courbe caractéristique d'atténuation (17) de l'atténuateur (5).

5. Dispositif selon la revendication 4, comprenant en outre un convertisseur A/N (14) destiné à la numérisation de la première et de la deuxième tension continue (15, 16).

6. Dispositif selon au moins l'une des revendications 4 ou 5, pour lequel le diviseur de signal (2) est conçu en tant que diviseur de Wilkinson.

7. Appareil de terrain destiné à la mesure d'une grandeur de process physique ou chimique, comprenant au moins un capteur, qui génère des signaux haute fréquence, dont la fréquence varie avec l'au moins une grandeur de process, et un dispositif selon au moins l'une des revendications 4 à 6, destiné à l'exploitation des signaux haute fréquence.
